# EUROPEAN PATENT APPLICATION

(11) **EP 4 741 218 A1**
(43) Date of publication of application: **13.05.2026**
(21) Application number: 24211875.0
(22) Date of filing: 08.11.2024
(51) Int. Cl.: B60L 53/80, B60L 58/12, B60L 58/16

(54) **A CONTROLLER AND A METHOD FOR LIFECYCLE MANAGEMENT OF A BATTERY ENERGY STORAGE SYSTEM**

(71) Applicant: Volvo Energy AB, 405 08 Gothenburg (SE)
(72) Inventor: JANA, Malay, 721301 Midnapur West (IN); MOHANAN, Harish, 680505 Guruvayur (IN); SENGUPTA, Amrita, 560073 Bangalore (IN); MISHRA, Nikhilesh, 600058 Chennai (IN)
(74) Representative: Zacco Sweden AB

(57) **Abstract**

A controller for lifecycle management of a battery energy storage system of an electric vehicle, wherein the controller is configured to: employ a lifecycle management model that defines a plurality of lifecycle options, wherein each lifecycle option has a priority level and is associated with minimum requirements with regard to one or more health indicators of the battery energy storage system; obtain data points for the one or more health indicators from the battery energy storage system; and determine a lifecycle decision based on the lifecycle management model and the obtained data points, wherein the lifecycle decision involves the selection of the lifecycle option that has the highest priority level and meets its associated minimum requirements.

## Description

### TECHNICAL FIELD

The disclosure relates generally to battery energy storage systems. In particular aspects, the disclosure relates to a controller and a method for lifecycle management of a battery energy storage system. The disclosure can be applied to heavy-duty vehicles, such as trucks, buses, and construction equipment, as well as other applications that utilize battery energy storage systems. Although the disclosure may be described with respect to a particular vehicle, the disclosure is not restricted to any particular vehicle.

### BACKGROUND

The global transportation sector is undergoing a major transformation, shifting from fossil fuel-powered vehicles to electric vehicles powered by battery energy storage systems. As the battery energy storage systems in electric vehicles begin to underperform and can no longer deliver the required power under varying conditions, they are often recycled despite maintaining a significant portion of their original capacity. For instance, while these systems may still hold a substantial amount of capacity and energy, their inability to deliver the required power or energy throughput means they are not suitable for continued use in a vehicle under the same conditions. Consequently, the absence of a lifecycle management framework for these systems often leads to inefficient utilization and premature recycling.

Hence, there is a need for a comprehensive method to manage the lifecycle of battery energy storage systems, optimizing use and extending viability before recycling.

### SUMMARY

According to a first aspect of the disclosure, a controller for lifecycle management of an energy storage system of an electric vehicle is disclosed. The controller is configured to employ a lifecycle management model that defines a plurality of lifecycle options, wherein each lifecycle option has a priority level and is associated with minimum requirements with regard to one or more health indicators of the battery energy storage system. The controller is configured to obtain data points for the one or more health indicators from the battery energy storage system. The controller is further configured to determine a lifecycle decision based on the lifecycle management model and the obtained data points, wherein the lifecycle decision involves selecting the lifecycle option that has the highest priority level and meets its minimum requirements with regard to the obtained data points. The first aspect of the disclosure may seek to extend utilization of the battery energy storage system before recycling. A technical benefit may include enhanced utilization through lifecycle decisions based on the progression of health indicators.

Optionally in some examples, including in at least one preferred example, the lifecycle options, in order of priority level, comprise: retain the battery energy storage system in its current application; repurpose the battery energy storage system for a different application with lower minimum requirements; and recycle the battery energy storage system if no further application is viable. A technical benefit may include extending the battery's operational lifespan by repurposing for a different application before recycling.

Optionally in some examples, including in at least one preferred example, the lifecycle options further comprise: reparametrize the battery energy storage system in its current application, and wherein the order of priority is: retain, reparametrize, repurpose and recycle. A technical benefit may include extending the battery's operational lifespan by imposing restrictions, such as limiting battery output power. Moreover, the ability of onboard systems to promptly implement a decision to reparametrize minimizes vehicle downtime.

Optionally in some examples, including in at least one preferred example, the lifecycle options further comprise: repair the battery energy storage system, and wherein repair has a priority level below retain and above repurpose. A technical benefit may include extending the battery's operational lifespan by prioritizing maintenance and repair options before repurposing.

Optionally in some examples, including in at least one preferred example, the one or more health indicators comprise remaining cycle life and internal resistance growth. A technical benefit may include improving lifecycle decisions by using remaining cycle life and internal resistance growth, as these two health indicators complementarily reflect the battery's health status and can therefore enhance lifecycle decision-making.

Optionally in some examples, including in at least one preferred example, obtaining data points for the one or more health indicators comprises obtaining data points from a battery management system of the battery energy storage system. A technical benefit may include enabling prompt lifecycle decisions through direct access to health indicators from the battery management system.

Optionally in some examples, including in at least one preferred example, obtaining data points for the one or more health indicators comprises obtaining data points from physical testing of the battery energy storage system. A technical benefit may include enhancing lifecycle decision accuracy by incorporating data points from direct physical testing of the battery system, enabling access to health indicators that may otherwise be unavailable.

Optionally in some examples, including in at least one preferred example, obtaining data points for the one or more health indicators comprises obtaining usage data from the electric vehicle and processing said usage data to obtain data points for one or more health indicators. A technical benefit may include enhancing lifecycle decision accuracy by incorporating data points from usage data of the vehicle, enabling access to health indicators that depend on vehicle usage.

According to a second aspect of the disclosure, a central battery energy storage system (BESS) management node is disclosed. The central BESS management node for lifecycle management of a group of battery energy storage systems comprising a controller according to the first aspect of the disclosure. The second aspect of the disclosure may seek to extend utilization of the battery energy storage system before recycling. A technical benefit may include enhanced utilization through lifecycle decisions based on the progression of health indicators.

Optionally in some examples, including in at least one preferred example, the controller is further configured to: maintain a database of battery energy storage systems for which a lifecycle decision to repurpose has been made, wherein for each battery energy storage systems the obtained data points of one or more health indicators are stored; maintain a list of applications for which a repurposed energy storage systems has been requested, wherein each application has specified minimum requirements with regard to one or more health indicators; and match the available battery energy storage systems in the database to the applications in the list such that the specified minimum requirements are satisfied. A technical benefit may include facilitating repurposing decisions by improving the matching of available systems with applications according to specific health indicators and requirements.

According to a third aspect of the disclosure, a method for lifecycle management of an energy storage system of an electric vehicle is disclosed. The method comprises: employing a lifecycle management model that defines a plurality of lifecycle options, wherein each option has a priority level and is associated with minimum requirements with regard to one or more health indicators of the battery energy storage system; obtaining data points for the one or more health indicators from the battery energy storage system; and determining a lifecycle decision based on the lifecycle management model and the obtained data points, wherein the lifecycle decision involves selecting the lifecycle option that has the highest priority level and meets its minimum requirements with regard to the obtained data points. The third aspect of the disclosure may seek to extend utilization of the battery energy storage system before recycling. A technical benefit may include enhanced utilization through lifecycle decisions based on the progression of health indicators. In some examples, employing the lifecycle management model includes selectively activating the lifecycle management model based on a set of predefined criteria. The predefined criteria include, but not limited to, a default operational frequency and/or occurrence of fault signals of the BESS, among others.

Optionally in some examples, including in at least one preferred example, the method further comprises: maintaining a database of battery energy storage systems for which a lifecycle decision to repurpose has been made, wherein for each battery energy storage systems the obtained data points of one or more health indicators are stored; maintaining a list of applications for which a repurposed energy storage system has been requested, wherein each application has specified minimum requirements with regard to one or more health indicators; and matching the battery energy storage systems of the database with health indicators from the battery energy storage systems in the database with the minimum requirements of application on the list to determine whether any of the repurposed battery energy storage systems satisfy the minimum requirements of the application. A technical benefit may include facilitating repurposing decisions by improving the matching of available systems with applications according to specific health indicators and requirements.

Optionally in some examples, including in at least one preferred example, the lifecycle options, in order of priority level, comprise: retain the battery energy storage system in its current application; repurpose the battery energy storage system for a different application with lower minimum requirements; and recycle the battery energy storage system if no further application is viable. A technical benefit may include extending the battery's operational lifespan by repurposing for a different application before recycling.

Optionally in some examples, including in at least one preferred example, the lifecycle options further comprise: reparametrize the battery energy storage system in its current application, and wherein the order of priority is: retain, reparametrize, repurpose and recycle. A technical benefit may include extending the battery's operational lifespan by imposing restrictions, such as limiting battery output power. Moreover, the ability of onboard systems to promptly implement a decision to reparametrize minimizes vehicle downtime.

Optionally in some examples, including in at least one preferred example, the lifecycle options further comprise: repair the battery energy storage system, and wherein repair has a priority level below retain and above repurpose. A technical benefit may include extending the battery's operational lifespan by prioritizing maintenance and repair options before repurposing.

Optionally in some examples, including in at least one preferred example, the one or more health indicators comprise remaining cycle life and internal resistance growth. A technical benefit may include improving lifecycle decisions by using remaining cycle life and internal resistance growth, as these two health indicators independently reflect the battery's health status and can therefore enhance lifecycle decision-making.

Optionally in some examples, including in at least one preferred example, obtaining data points for the one or more health indicators comprises receiving data points from a battery management system of the battery energy storage system. A technical benefit may include enabling prompt lifecycle decisions through direct access to health indicators from the battery management system.

Optionally in some examples, including in at least one preferred example, obtaining data points for the one or more health indicators comprises obtaining data points from physical testing of the battery energy storage system. A technical benefit may include enhancing lifecycle decision accuracy by incorporating data points from direct physical testing of the battery system, enabling access to health indicators that may otherwise be unavailable.

Optionally in some examples, including in at least one preferred example, obtaining data points for the one or more health indicators comprises obtaining usage data from the electric vehicle and processing said usage data to obtain data points for one or more health indicators. A technical benefit may include enhancing lifecycle decision accuracy by incorporating data points from usage data of the vehicle, enabling access to health indicators that depend on vehicle usage.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.
FIG. 1 illustrates two electric heavy-duty vehicles connected wirelessly to a central management node equipped with a controller for lifecycle management of battery energy storage systems, according to an example.
FIG. 2A shows a spider chart of health indicator data points used to determine the lifecycle decision based on priority levels and minimum requirements in the lifecycle management model.
FIG. 2B shows the same example as FIG. 2A, but with an alternate set of data points.
FIG. 3 is a flowchart of a method for lifecycle management of an energy storage system of an electric vehicle.
FIG. 4A schematically illustrates a control unit.
FIG. 4B shows an example of a computer program product.
FIG. 5 is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

Battery energy storage systems are utilized in both heavy and light electric vehicles, marine vessels, and a diverse array of applications, including grid support, generator sets, and storage for intermittent renewable energy sources. These applications often have varying requirements, such as power output and durability under different operational conditions. Therefore, a key concept of this disclosure is to provide a lifecycle management approach that considers the requirements of different applications to enable multiple reuse and repurposing pathways before a lifecycle decision to recycle a battery energy storage system is made. It should be noted that, in this disclosure, the term battery energy storage system comprises any rechargeable battery pack capable of storing and supplying electrical energy for a range of applications, including but not limited to electric vehicles, grid support, and renewable energy storage. For brevity, the terms 'battery' and 'battery energy storage systems' will sometimes be used interchangeably.

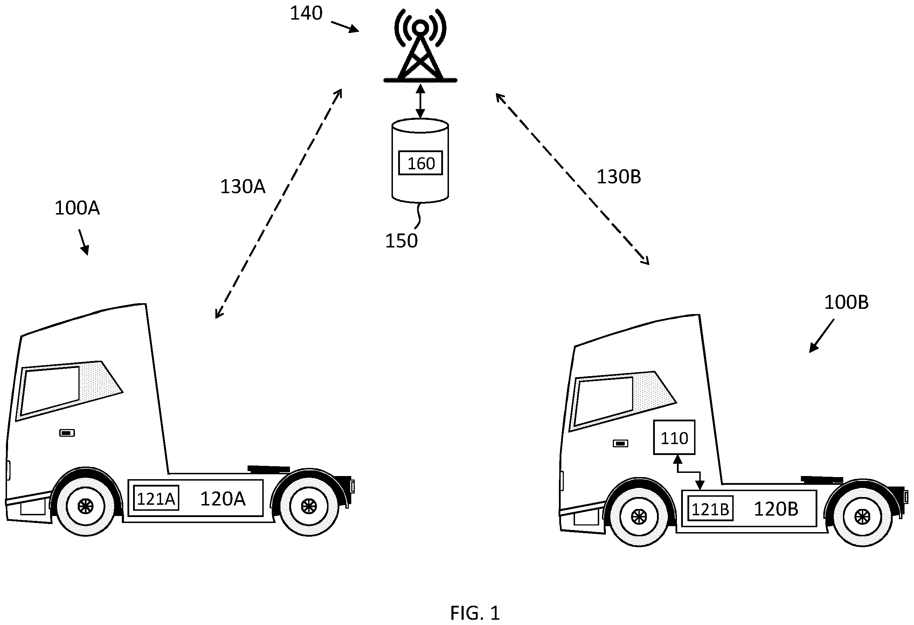

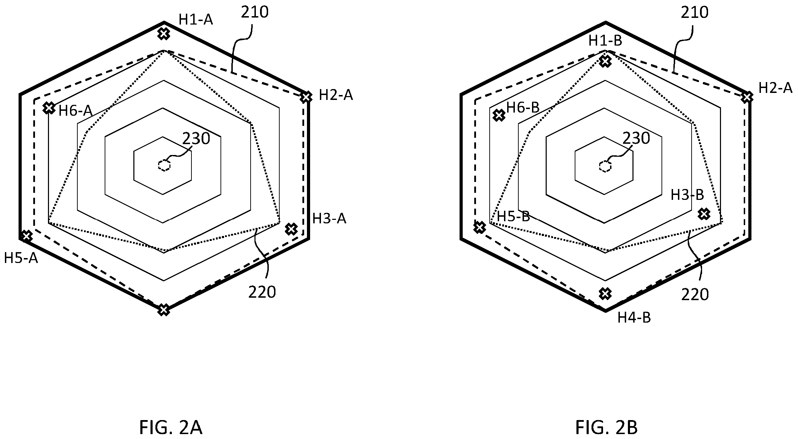

FIGS. 1, 2A and 2B illustrate a first aspect of the disclosure relating to a controller 110, 160 for lifecycle management of an energy storage system 120A, 120B.

FIG. 1 illustrates two electric heavy-duty vehicles 100A, 100B connected via wireless links 130A, 130B to a central management node 150 equipped with a controller 160 for lifecycle management of battery energy storage systems. The vehicles 100A, 100B connect via wireless links 130A, 130B to a wireless network 140, e.g., a 3GPP-compliant wireless network, enabling communication with a central batter energy storage system (BESS) management node 150 comprising a controller 160. The central BESS node 150 may be implemented on a cloud server but it could also be any other type of server, such as an edge server, data center server, or on-premises server, capable of connecting to the wireless network 140. Each vehicle 100A, 100B comprises a battery energy storage system 120A, 120B for powering the vehicle's propulsion system and supports auxiliary functions, and will typically include a battery management system (BMS) 121A, 121B that monitors and reports key battery health indicators such as state of charge (SoC), state of health (SoH), and cycle life. FIG. 1 also illustrates an alternative approach in which the electric heavy-duty vehicle 100B includes an onboard controller 110 for local lifecycle management of its battery energy storage system 120B.

The controller 110, 160 is configured to employ a lifecycle management model that defines a plurality of lifecycle options. Each of the lifecycle options has a priority level and is associated with minimum requirements with regard to one or more health indicators of the battery energy storage system 120A, 120B. The controller 110, 160 is further configured to obtain data points for the one or more health indicators from the battery energy storage system 120A, 120B, apply the obtained data points to the lifecycle management model. Applying the obtained data points to the lifecycle management model simply means that the obtained data points are used in conjunction with the lifecycle management model. Lastly, the controller is configured to determine a lifecycle decision based on the lifecycle management model and the obtained data points. The lifecycle decision is the lifecycle option that has the highest priority level and meets its associated minimum requirements with regard to the obtained data points.

In its broadest example, the lifecycle model includes three lifecycle options, listed in order of priority: retain the battery energy storage system 120A, 120B in current application, repurpose the battery energy storage system 120A, 120B for a different application, and recycle the battery energy storage system 120A, 120B. Retain in current application has the highest priority, meaning that if the battery energy storage system 120 meets the minimum requirements of that option, it will continue to be used in its current setting, such as in a vehicle 100A, 100B. This prioritization aims to maximize the battery's original use efficiently before considering options that require additional processing, i.e., repurposing or recycling. If the minimum requirements to retain in current application are not met, the lifecycle option to repurpose for a different application is the next lifecycle option in order of priority. This means that if the battery energy storage system 120A, 120B meets the minimum requirements for the repurpose option, a decision to repurpose the battery energy storage system 120A, 120B will be made. For example, the battery energy storage system could be repurposed for use in a lighter vehicle with lower performance requirements or adapted for grid support in an energy storage system, where power demand can be managed more predictably. It should be noted that a decision to repurpose will almost always involve some degree of reparameterization of the battery to align with the requirements of the new application. If the minimum requirements to retain or repurpose are not met, a decision is made to recycle the battery energy storage system 120A, 120B as the third and last option.

The above example may be extended to further include the lifecycle option reparametrize the battery energy storage system 120A, 120B in its current application. The lifecycle options then comprise, listed in order of priority: retain in current application, reparametrize in current application, repurpose for a different application, and recycle. Reparametrize in current application may involve imposing restrictions on battery settings, such as limiting power output, that may lower the performance but allow continued use in the current application. An advantage of this approach is that a decision to reparametrize can be promptly implemented by the onboard systems in the vehicle and does not require visiting a service point.

The above example may also be extended to further include the lifecycle option repair. Repair might encompass performing maintenance or addressing issues that have arisen during its operational life, thereby extending its usability without the need to replace the entire system. Repair may be a viable lifecycle option if health indicators suggest that the battery can be repaired; for example, if a health indicator such as cell voltage imbalance indicates that battery cells can be rebalanced, repairing the battery may be more beneficial than reparametrizing or repurposing it.

In some scenarios, particularly when there is high demand for repurposed batteries in other applications, a lifecycle decision to repair may involve repairing the battery for a different application. The vehicle 100A, 100B would then receive a new battery energy storage system, while the system designated for repair could be used in a different application after repair. Accordingly, the lifecycle option of repair encompasses both: repair for current application (i.e., repair and retain) and repair for a different application (i.e., repair and repurpose). It should also be noted that repair will typically involve some degree of reparameterization of the battery. The lifecycle options, in order of priority, are: retain in current application, repair, repurpose for a different application, and recycle. If reparametrize is also considered, the lifecycle options, in order of priority, are: retain in current application, reparametrize in current application, repair, repurpose for a different application, and recycle. Hence, repair has a priority level below retain and above repurpose.

The above example may be extended yet again to further include the lifecycle options refurbish and remanufacture. Refurbish may involve taking older systems and upgrading specific components to restore them to a functional condition. Remanufacture may involve disassembling and reusing parts of old systems to create new ones. An advantage of the examples described above is that they provide a broad range of lifecycle options, prioritizing reuse and recovery pathways before considering recycling. Refurbish and Remanufacture may also involve reparameterization of the battery.

As previously mentioned, the lifecycle options are associated with minimum requirements with regard to one or more health indicators of the battery energy storage system 120A, 120B. Any number of health indicators may be used, and different applications may have specific requirements for different indicators. In one example, the one or more health indicators comprise remaining cycle life and internal resistance growth. One technical advantage of using these two health indicators is that they provide complementary measures of the battery's condition, allowing for improved accuracy in the lifecycle decision. Other examples of health indicators include, but are not limited to: state of health (SoH), energy throughput, minimum and maximum cell voltages during any session (e.g., charging or driving), average pack temperature during any session, remaining battery capacity, internal resistance growth, capacity variation among cells, and resistance variation among cells. For example, a charging session refers to a duration of time for which the electric vehicle is connected to a charging point for charging. Similarly, a driving session refers to a duration of time for which the electric vehicle is in driving mode.

The minimum requirements for lifecycle option to retain the battery energy storage system in its current application are influenced by various factors, including the specifications of the battery energy storage system, the application type, and the specific demands of that application. Typically, a vehicle 100A, 100B may have defined minimum requirements that must be met for the battery energy storage system 120A, 120B to be retained in its current application. These minimum requirements set a performance threshold below which the battery is considered inadequate. The minimum requirements may typically be determined through simulations or extensive field tests conducted on similar vehicles under comparable usage conditions.

The minimum requirements for the lifecycle option to repurpose the battery energy storage system for a different application will typically depend on what other types of applications are available for consideration. For example, the battery energy storage system could be repurposed for use in a lighter vehicle with lower performance requirements or adapted for grid support in an energy storage system, where power demand can be managed more predictably. Thus, the minimum requirements for repurposing depend on the minimum requirements of these applications. Similarly, these requirements may have been determined through simulations or extensive field tests conducted on the same type of application and under similar usage conditions.

There are typically no minimum performance requirements for the life cycle option to recycle, as this option is selected only when no other lifecycle option remains viable. Recycling serves as the final stage, ensuring that valuable materials are recovered from the battery when repurposing or continued use is no longer feasible.

The minimum requirements for other lifecycle options, such as reparametrize and repair, can be determined similarly through simulations and field tests. Reparametrize is an option when performance requirements may be reduced. Repair may address specific health indicator that indicate a problem, such as capacity variation among cells or resistance variation between cells, while maintaining the functionality of the rest of the battery system.

The minimum requirements for other lifecycle options: reparametrize and repair can be obtained in a similar manner through simulation and field tests. Reparametrize is an option for applications where performance requirements may be lowered. Repair may target specific health indicators that indicate a specific problem within an otherwise functional battery. For example, it may address health indicators such as capacity variation among cells or resistance differences between cells.

The controller 110, 160 is configured to obtain data points for one or more health indicators. The data points may be any observed or estimated value of a health indicator and can therefore be used to evaluate the minimum requirements for each option in the lifecycle model. The data points may also in some examples be a value indicative of a health indicator, that may require some processing before being applied to the lifecycle model. Obtaining data points for the one or more health indicators may comprise obtaining data points from the battery management system 121A, 121B of the battery energy storage system 120A, 120B. According to some examples, the controller 160 of the central management node 150 may obtain data points from the vehicle 100A, 100B via the wireless link 130A, 130B. Obtaining the data points can be continuous, periodic, intermittent, or at pre-determined intervals. That is, in one example, data points may be obtained from the vehicle 120A, 120B after completion of a session. In a further example, the BMS 121A, 121B may communicate the data points corresponding to the health indicator to a vehicle controller, which is configured to communicate with the management node 150. Health indicators typically obtained from BMS include, but are not limited to, SoH, energy throughput, minimum and maximum cell voltages during any session (e.g., charging or driving), and average pack temperature during any session. Obtaining data points for the one or more health indicators may also comprise obtaining data points from physical testing of the battery energy storage system 121A, 121B. Health indicators typically obtained from physical testing include, but are not limited to, remaining battery capacity, internal resistance growth, capacity variation across cells, and resistance differences between cells.

Obtaining data points for the one or more health indicators may also comprise obtaining usage data from the electric vehicle and processing said usage data to obtain data points for one or more health indicators. Usage data may include, but is not limited to, period of usage (e.g., years, days, months, etc. of use of the BESS), average temperature during idle conditions, state of charge during each session (charging/driving), average discharge C-rate during driving sessions, and the percentage of time the vehicle is fast-charged. For example, the health indicator 'remaining cycle life' may be determined under standard usage conditions, which may also be adjusted based on BMS and usage data including temperature, C-rate, and depth of discharge (DoD).

Obtaining data points for the one or more health indicators may in some examples comprise: receiving input data points from a battery management system 121A, 121B of the battery energy storage system 120A, 120B; receiving usage data from the electric vehicle 100A, 100B; and obtaining data points for one or more health indicators by combining the input data points and the usage data. For example, the health indicator 'remaining cycle life' may be determined from input data points under standard usage conditions, which may be adjusted based on BMS and usage data including temperature, C-rate, and DoD. This approach of combining input data points with usage data may have the advantage of obtaining data points for certain health indicators more efficiently and accurately by also taking usage data into account.

According to an alternative interpretation of the above, input data points are obtained, e.g., from a BMS, and are used to compute health indicators. There are two scenarios here. In the first scenario, the data points directly correspond to health indicators. In the second scenario, the data points may require additional calculations to determine the health indicators before being used with the model.

FIGS. 2A and 2B provide two examples using spider charts to illustrate the minimum requirements for three lifecycle options - retain 210, repurpose 220, and recycle 230 - in relation to six different health indicators. FIG. 2A displays data points H1-A, H2-A, H3-A, H4-A, H5-A, H6-A, while FIG. 2B presents different data points H1-B, H2-B, H3-B, H4-B, H5-B, H6-B. For the data points of FIG. 2A, the minimum requirements for retain 210 are not met due to data point H6-A, prompting a decision to repurpose the battery energy storage system as repurpose 220 meets all data points. For the data points in FIG. 2B, neither the requirements for repurpose 220 are met due to data point H3-B, leading to a decision to recycle the battery. These two examples demonstrate how different data points lead to different lifecycle decisions, highlighting the relevance of the priority level and minimum requirements for each lifecycle option.

FIGS. 1, 2A and 2B also illustrate a second aspect of the disclosure relating to a central battery energy storage system, BESS, management node 150 for lifecycle management of a group of battery energy storage systems 120A, 120B comprising a controller 160 according to the first aspect of the disclosure.

The controller may 160 may further be configured to: maintain a database of battery energy storage systems for which a lifecycle decision to repurpose has been made, wherein for each battery energy storage systems the obtained data points of one or more health indicators are stored; maintain a list of applications for which a repurposed energy storage systems has been requested, wherein each application has specified minimum requirements with regard to one or more health indicators; and match the available battery energy storage systems in the database to the applications in the list such that the specified minimum requirements are satisfied. By this approach, the central BESS node 150 may function as a centralized lifecycle decision hub for a large group of battery energy storage systems 120A, 120B. In one example, applications that require a battery energy storage system can then request one along with specified minimum requirements, and the central BESS node will match the request to any available battery energy storage system that meets the specified minimum requirements. The central BESS node 150 will typically be implemented on a cloud server but could also be implemented on any other type of server, such as an edge server, data center server, or on-premises server.

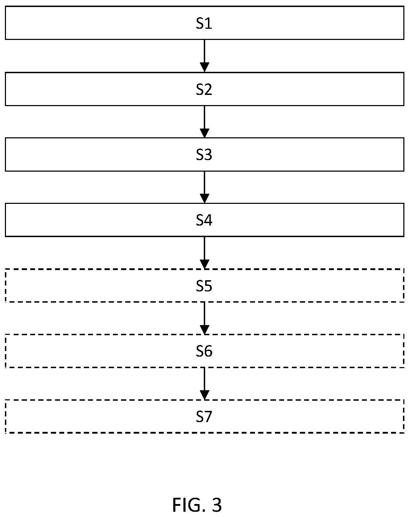

FIG. 3 illustrates a third aspect of the disclosure relating to a method for lifecycle management of an energy storage system 120. The method comprises employing S1 a lifecycle management model, obtaining S2 data points for the one or more health indicators, applying S3 the obtained data points to the lifecycle management model, and determining S4 a lifecycle decision by applying the obtained data points to the lifecycle management model. It should be noted that all the aforementioned aspects concerning the controller 110, 160, and the central BESS node 150 are equally applicable to the method. Specifically, the described lifecycle options and health indicators are also utilized in this method.

The method comprises employing S1 a lifecycle management model that defines a plurality of lifecycle options, wherein each option has a priority level and is associated with minimum requirements with regard to one or more health indicators of the battery energy storage system 120A, 120B. The method further comprises obtaining S2 data points for the one or more health indicators from the battery energy storage system 120A, 120B. Applying S3 the obtained data points to the lifecycle management model simply means that the obtained data points are used in conjunction with the lifecycle management model. Determining S4 a lifecycle decision based on the lifecycle management model and the obtained data, wherein the lifecycle decision is the lifecycle option that has the highest priority level and meets its minimum requirements with regard to the data points.

The method may further comprise maintaining S5 a database of battery energy storage systems for which a lifecycle decision to repurpose has been made, wherein for each battery energy storage systems the obtained data points of one or more health indicators are stored, and maintaining S6 a list of applications for which a repurposed energy storage system has been requested, wherein each application has specified minimum requirements with regard to one or more health indicators. Utilizing the database and the list of applications enables matching S7 the available battery energy storage systems in the database to the applications in the list such that the specified minimum requirements are satisfied.

Obtaining S2 data points for the one or more health indicators may in some examples comprise: receiving input data points from a battery management system 121A, 121B of the battery energy storage system 120A, 120B; receiving usage data from the electric vehicle 100A, 100B; and obtaining data points for one or more health indicators by combining the input data points and the usage data. For example, the health indicator 'remaining cycle life' may be determined from input data points under standard usage conditions, which may be adjusted based on BMS and usage data including temperature, C-rate, and DoD.

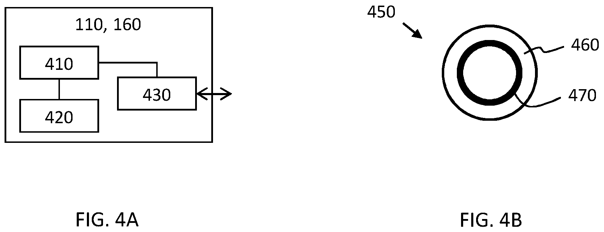

FIG. 4A schematically illustrates, in terms of a number of functional units, the components of a control unit 110 according to aspects of the discussions and methods disclosed herein. This control unit 110 may typically be comprised in the vehicle 100. Processing circuitry 410 is provided using any combination of one or more of a suitable central processing unit CPU, multiprocessor, microcontroller, digital signal processor DSP, etc., capable of executing software instructions stored in a computer program product, e.g., in the form of a storage medium 420. The processing circuitry 410 may further be provided as at least one application specific integrated circuit ASIC, or field programmable gate array FPGA.

Particularly, the processing circuitry 410 is configured to cause the control unit 110 to perform a set of operations, or steps, such as the methods discussed in connection to FIG. 3. For example, the storage medium 420 may store the set of operations, and the processing circuitry 410 may be configured to retrieve the set of operations from the storage medium 420 to cause the control unit 110 to perform the set of operations. The set of operations may be provided as a set of executable instructions. Thus, the processing circuitry 410 is thereby arranged to execute methods as herein disclosed.

The storage medium 420 may also comprise persistent storage, which, for example, can be any single one or combination of magnetic memory, optical memory, solid state memory or even remotely mounted memory.

The control unit 110, 160 may further comprise an interface 430 for communications with at least one external system, such as a wireless network 140, and a central BESS node 150. As such the interface 430 may comprise one or more transmitters and receivers, comprising analogue and digital components and a suitable number of ports for wireline or wireless communication.

The processing circuitry 410 controls the general operation of the control unit 110, 160, e.g., by sending data and control signals to the interface 430 and the storage medium 420, by receiving data and reports from the interface 430, and by retrieving data and instructions from the storage medium 420. Other components, as well as the related functionality, of the control node are omitted in order not to obscure the concepts presented herein.

FIG. 4B shows an example of a computer program product. A computer readable medium 460 carrying a computer program 470 comprising program code means for performing the steps of aforementioned method when said program product is run on a computer or on processing circuitry 410 of a control unit 110.

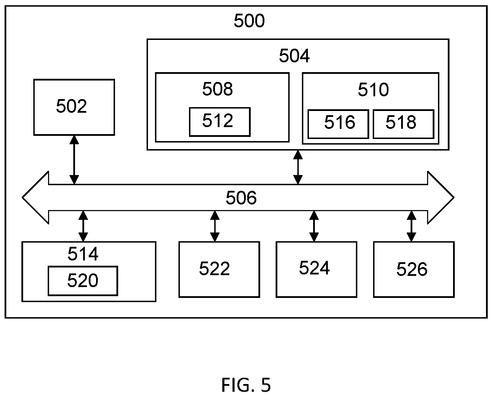

FIG. 5 is a schematic diagram of a computer system 500 for implementing examples disclosed herein. The computer system 500 is adapted to execute instructions from a computer-readable medium to perform these and/or any of the functions or processing described herein. The computer system 500 may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system 500 may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 500 may comprise at least one computing device or electronic device capable of including firmware, hardware, and/or executing software instructions to implement the functionality described herein. The computer system 500 may include processing circuitry 502 (e.g., processing circuitry including one or more processor devices or control units), a memory 504, and a system bus 506. The computer system 500 may include at least one computing device having the processing circuitry 502. The system bus 506 provides an interface for system components including, but not limited to, the memory 504 and the processing circuitry 502. The processing circuitry 502 may include any number of hardware components for conducting data or signal processing or for executing computer code stored in memory 504. The processing circuitry 502 may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry 502 may further include computer executable code that controls operation of the programmable device.

The system bus 506 may be any of several types of bus structures that may further interconnect to a memory bus (with or without a memory controller), a peripheral bus, and/or a local bus using any of a variety of bus architectures. The memory 504 may be one or more devices for storing data and/or computer code for completing or facilitating methods described herein. The memory 504 may include database components, object code components, script components, or other types of information structure for supporting the various activities herein. Any distributed or local memory device may be utilized with the systems and methods of this description. The memory 504 may be communicably connected to the processing circuitry 502 (e.g., via a circuit or any other wired, wireless, or network connection) and may include computer code for executing one or more processes described herein. The memory 504 may include non-volatile memory 508 (e.g., read-only memory (ROM), erasable programmable read-only memory (EPROM), electrically erasable programmable read-only memory (EEPROM), etc.), and volatile memory 510 (e.g., random-access memory (RAM)), or any other medium which can be used to carry or store desired program code in the form of machine-executable instructions or data structures and which can be accessed by a computer or other machine with processing circuitry 502. A basic input/output system (BIOS) 512 may be stored in the non-volatile memory 508 and can include the basic routines that help to transfer information between elements within the computer system 500.

The computer system 500 may further include or be coupled to a non-transitory computer-readable storage medium such as the storage device 514, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 514 and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device 514 and/or in the volatile memory 510, which may include an operating system 516 and/or one or more program modules 518. All or a portion of the examples disclosed herein may be implemented as a computer program 520 stored on a transitory or non-transitory computer-usable or computer-readable storage medium (e.g., single medium or multiple media), such as the storage device 514, which includes complex programming instructions (e.g., complex computer-readable program code) to cause the processing circuitry 502 to carry out actions described herein. Thus, the computer-readable program code of the computer program 520 can comprise software instructions for implementing the functionality of the examples described herein when executed by the processing circuitry 502. In some examples, the storage device 514 may be a computer program product (e.g., readable storage medium) storing the computer program 520 thereon, where at least a portion of a computer program 520 may be loadable (e.g., into a processor) for implementing the functionality of the examples described herein when executed by the processing circuitry 502. The processing circuitry 502 may serve as a controller or control system for the computer system 500 that is to implement the functionality described herein.

The computer system 500 may include an input device interface 522 configured to receive input and selections to be communicated to the computer system 500 when executing instructions, such as from a keyboard, mouse, touch-sensitive surface, etc. Such input devices may be connected to the processing circuitry 502 through the input device
interface 522 coupled to the system bus 506 but can be connected through other interfaces, such as a parallel port, an Institute of Electrical and Electronic Engineers (IEEE) 1394 serial port, a Universal Serial Bus (USB) port, an IR interface, and the like. The computer system 500 may include an output device interface 524 configured to forward output, such as to a display, a video display unit (e.g., a liquid crystal display (LCD) or a cathode ray tube (CRT)). The computer system 500 may include a communications interface 526 suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1: A controller 110, 160 for lifecycle management of a battery energy storage system 120A, 120B of an electric vehicle 100A, 100B, wherein the controller is configured to: employ a lifecycle management model that defines a plurality of lifecycle options, wherein each lifecycle option has a priority level and is associated with minimum requirements with regard to one or more health indicators of the battery energy storage system 120A, 120B; obtain data points for the one or more health indicators from the battery energy storage system 120A, 120B; apply the obtained data points to the lifecycle management model; and determine a lifecycle decision based on the lifecycle management model and the obtained data points, wherein the lifecycle decision involves the selection of the lifecycle option that has the highest priority level and meets its minimum requirements.

Example 2: The controller 110, 160 of example 1, wherein the lifecycle options, in order of priority level, comprise: retain the battery energy storage system 120A, 120B in its current application; repurpose the battery energy storage system 120A, 120B for a different application with lower minimum requirements; and recycle the battery energy storage system 120A, 120B if no further application is viable.

Example 3: The controller 110, 160 of example 2, wherein the lifecycle options further comprise: reparametrize the battery energy storage system 120A, 120B in its current application, and wherein the order of priority is: retain, reparametrize, repurpose and recycle.

Example 4: The controller 110, 160 of any of examples 2-3, wherein the lifecycle options further comprise: repair the battery energy storage system 120A, 120B, and wherein repair has a priority level below retain and above repurpose.

Example 5: The controller 110, 160 of any of examples 1-4, wherein the one or more health indicators comprise remaining cycle life and internal resistance growth.

Example 6: The controller 110, 160 of any of examples 1-5, wherein obtaining data points for the one or more health indicators comprises obtaining data points from a battery management system 121A, 121B of the battery energy storage system 120A, 120B.

Example 7: The controller 110, 160 of any of examples 1-6, wherein obtaining data points for the one or more health indicators comprises obtaining data points from physical testing of the battery energy storage system 120A, 120B.

Example 8: The controller 110, 160 of any of examples 1-7, wherein obtaining data points for the one or more health indicators comprises obtaining usage data from the electric vehicle 100A, 100B and processing said usage data to obtain data points for one or more health indicators.

Example 9: A central battery energy storage system, BESS, management node 150 for lifecycle management of a group of battery energy storage systems 120A, 120B comprising a controller 160 according to any of examples 1-8.

Example 10: The central BESS management node 150 of example 9, wherein the controller 160 is further configured to: maintain a database of battery energy storage systems for which a lifecycle decision to repurpose has been made, wherein for each battery energy storage systems the obtained data points of one or more health indicators are stored; maintain a list of applications for which a repurposed energy storage systems 120 has been requested, wherein each application has specified minimum requirements with regard to one or more health indicators; and match the available battery energy storage systems in the database to the applications in the list such that the specified minimum requirements are satisfied.

Example 11: A method for lifecycle management of an energy storage system 120A, 120B of an electric vehicle 100A, 100B, wherein the method comprises: employing S1 a lifecycle management model that defines a plurality of lifecycle options, wherein each lifecycle option has a priority level and is associated with minimum requirements with regard to one or more health indicators of the battery energy storage system 120A, 120B; obtaining S2 data points for the one or more health indicators from the battery energy storage system 120A, 120B; applying S3 the obtained data points to the lifecycle management model; and determining S4 a lifecycle decision based on the lifecycle management model and the obtained data, wherein the lifecycle decision involves the selection of the lifecycle option that has the highest priority level and meets its minimum requirements.

Example 12A: The method of example 11, wherein the method further comprises: maintaining S5 a database of battery energy storage systems for which a lifecycle decision to repurpose has been made, wherein for each battery energy storage systems the obtained data points of one or more health indicators are stored; maintaining S6 a list of applications for which a repurposed energy storage system 120 has been requested, wherein each application has specified minimum requirements with regard to one or more health indicators; and matching S7 the available battery energy storage systems in the database to the applications in the list such that the specified minimum requirements are satisfied.

Example 12B: The method of any of claims 9-11, wherein obtaining S2 data points for the one or more health indicators further comprises: receiving input data points from a battery management system 121A, 121B of the battery energy storage system 120A, 120B; receiving usage data from the electric vehicle 100A, 100B; and obtaining data points for one or more health indicators by combining the input data points and the usage data.

Example 13: The method of any of examples 11-12, The method of any of examples 9-10, wherein the lifecycle options, in order of priority level, comprise: retain the battery energy storage system 120A, 120B in its current application; repurpose the battery energy storage system 120A, 120B for a different application with lower minimum requirements; and recycle if no further application is viable.

Example 14: The method of example 13, wherein the lifecycle options further comprise: reparametrize the battery energy storage system 120A, 120B in its current application, and wherein the order of priority is: retain, reparametrize, repurpose and recycle.

Example 15: The method of any of examples 13-14, wherein the lifecycle options further comprise: repair the battery energy storage system 120A, 120B; and wherein repair has a priority level below retain and above repurpose.

Example 16: The method of any of examples 11-15, wherein obtaining data points for the one or more health indicators comprises receiving data points from a battery management system 121A, 121B of the battery energy storage system 120.

Example 17: The method of any of examples 11-16, wherein obtaining data points for the one or more health indicators comprises obtaining data points from physical testing of the battery energy storage system 120A, 120B.

Example 18: The method of any of examples 11-17, wherein obtaining data points for the one or more health indicators comprises obtaining usage data from the electric vehicle 100A, 100B and processing said usage data to obtain data points for one or more health indicators.

Example 19: A computer program product comprising program code for performing, when executed by the processing circuitry, the method of any of examples 11-18.

Example 20: A non-transitory computer-readable storage medium comprising instructions, which when executed by the processing circuitry, cause the processing circuitry to perform the method of any of examples 11-18.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A controller (110, 160) for lifecycle management of a battery energy storage system (120A, 120B) of an electric vehicle (100A, 100B), wherein the controller is configured to:
employ a lifecycle management model that defines a plurality of lifecycle options, wherein each lifecycle option has a priority level and is associated with minimum requirements with regard to one or more health indicators of the battery energy storage system (120A, 120B);
obtain data points for the one or more health indicators from the battery energy storage system (120A, 120B);
apply the obtained data points to the lifecycle management model; and
determine a lifecycle decision based on the lifecycle management model and the obtained data points, wherein the lifecycle decision involves the selection of the lifecycle option that has the highest priority level and meets its associated minimum requirements.

2. The controller (110, 160) of claim 1, wherein the lifecycle options, in order of priority level, comprise:
retain the battery energy storage system (120A, 120B) in its current application;
repurpose the battery energy storage system (120A, 120B) for a different application with lower minimum requirements; and
recycle the battery energy storage system (120A, 120B) if no further application is viable.

3. The controller (110, 160) of claim 2, wherein the lifecycle options further comprise: reparametrize the battery energy storage system (120A, 120B) in its current application, and wherein the order of priority is: retain, reparametrize, repurpose and recycle.

4. The controller (110, 160) of any of claims 2-3, wherein the lifecycle options further comprise: repair the battery energy storage system (120A, 120B), and wherein repair has a priority level below retain and above repurpose.

5. The controller (110, 160) of any of claims 1-4, wherein the one or more health indicators comprise remaining cycle life and internal resistance growth.

6. The controller (110, 160) of any of claims 1-5, wherein obtaining data points for the one or more health indicators comprises at least one of:
obtaining data points from a battery management system (121A, 121B) of the battery energy storage system (120A, 120B);
obtaining data points from physical testing of the battery energy storage system (120A, 120B); and
obtaining usage data from the electric vehicle (100A, 100B) and processing said usage data to obtain data points for one or more health indicators.

7. A central battery energy storage system, BESS, management node (150) for lifecycle management of a group of battery energy storage systems (120A, 120B) comprising a controller (160) according to any of claims 1-6.

8. The central BESS management node (150) of claim 7, wherein the controller (160) is further configured to:
maintain a database of battery energy storage systems for which a lifecycle decision to repurpose has been made, wherein for each battery energy storage systems the obtained data points of one or more health indicators are stored;
maintain a list of applications for which a repurposed battery energy storage system has been requested, wherein each application has specified minimum requirements with regard to one or more health indicators; and
match the available battery energy storage systems in the database to the applications in the list such that the specified minimum requirements are satisfied.

9. A method for lifecycle management of an energy storage system (120A, 120B) of an electric vehicle (100A, 100B), wherein the method comprises:
employing (S 1) a lifecycle management model that defines a plurality of lifecycle options, wherein each lifecycle option has a priority level and is associated with minimum requirements with regard to one or more health indicators of the battery energy storage system (120A, 120B);
obtaining (S2) data points for the one or more health indicators from the battery energy storage system (120A, 120B);
applying the (S3) the obtained data points to the lifecycle management model; and
determining (S4) a lifecycle decision based on the lifecycle management model and the obtained data, wherein the lifecycle decision involves the selection of the lifecycle option that has the highest priority level and meets its associated minimum requirements.

10. The method of claim 9, wherein the method further comprises:
maintaining (S5) a database of battery energy storage systems for which a lifecycle decision to repurpose has been made, wherein for each battery energy storage systems the obtained data points of one or more health indicators are stored;
maintaining (S6) a list of applications for which a repurposed energy storage system (120) has been requested, wherein each application has specified minimum requirements with regard to one or more health indicators; and
matching (S7) the available battery energy storage systems in the database to the applications in the list such that the specified minimum requirements are satisfied.

11. The method of any of claims 9-10, wherein the lifecycle options, in order of priority level, comprise:
retain the battery energy storage system (120A, 120B) in its current application;
repurpose the battery energy storage system (120A, 120B) for a different application with lower minimum requirements; and
recycle if no further application is viable.

12. The method of any of claims 9-11, wherein obtaining (S2) data points for the one or more health indicators further comprises:
receiving input data points from a battery management system (121A, 121B) of the battery energy storage system (120A, 120B);
receiving usage data from the electric vehicle (100A, 100B); and
obtaining data points for one or more health indicators by combining the input data points and the usage data.

13. The method of claim 12, wherein the lifecycle options further comprise: repair the battery energy storage system (120A, 120B); and wherein repair has a priority level below retain and above repurpose.

14. The method of any of claims 9-13, wherein obtaining (S2) data points for the one or more health indicators comprises at least one of:
obtaining data points from a battery management system (121A, 121B) of the battery energy storage system (120A, 120B);
obtaining data points from physical testing of the battery energy storage system (120A, 120B); and
obtaining usage data from the electric vehicle (100A, 100B) and processing said usage data to obtain data points for one or more health indicators.

15. A non-transitory computer-readable storage medium comprising instructions, which when executed by the processing circuitry, cause the processing circuitry to perform the method of any of claims 9-14.
